# EUROPEAN PATENT APPLICATION

(11) **EP 4 748 979 A1**
(43) Date of publication of application: **27.05.2026**
(21) Application number: 25170937.4
(22) Date of filing: 16.04.2025
(51) Int. Cl.: C30B 13/16, C30B 13/28, C30B 29/16

(54) **APPARATUS FOR PRODUCING OXIDE SINGLE CRYSTAL, METHOD FOR PRODUCING GALLIUM OXIDE SINGLE CRYSTALS USING THE APPARATUS, AND GALLIUM OXIDE SINGLE CRYSTAL PRODUCED THEREBY**

(30) Priority: 21.11.2024 KR 20240167299
(71) Applicant: Pusan National University Industry-University Cooperation Foundation, Busan 46241 (KR)
(72) Inventor: Ok, Jong Mok, 46241 Geumjeong-gu, Busan (KR); Choe, Byeongcheol, 46241 Geumjeong-gu, Busan (KR); Park, Sungkyun, 46241 Geumjeong-gu, Busan (KR); Lee, Younghyun, 46241 Geumjeong-gu, Busan (KR)
(74) Representative: Gulde & Partner

(57) **Abstract**

The present disclosure relates to an apparatus for producing an oxide single crystal, a method of producing a gallium oxide single crystal using the same, and a gallium oxide single crystal produced thereby. More specifically, the present disclosure relates to an apparatus for producing a single crystal and a method for producing a gallium oxide single crystal using the same, which may minimize the problem of impurities being introduced by a crucible, by applying a method of using the oxide pellets themselves, which are to be made into a single crystal, as a crucible without using a separate crucible, and maintain the growth atmosphere of the oxide single crystal at a high-oxygen atmosphere by applying a method of generating heat using a flame consisting of a mixture of a hydrocarbon fuel gas and oxygen gas, thereby producing a high-quality oxide single crystal with few defects.

## Description

### BACKGROUND

### 1. Technical Field

The present disclosure relates to an apparatus for producing an oxide single crystal, a method for producing a gallium oxide single crystal using the apparatus, and a gallium oxide single crystal produced thereby.

### 2. Related Art

Since single crystal growth by the FZ method or the CZ method was reported by Y. Tomm, et al. in 2000, a single crystal of gallium oxide (particularly a β-Ga₂O₃ single crystal, the following description will refer to β-Ga₂O₃ single crystal) has been studied and developed initially for crystal growth thereof as a substrate for producing a GaN thin film for LED.

In recent years, M. Higashiwaki, et al. have reported the realization of a FET for a power device using a β-Ga₂O₃ single crystal, and there has been strong interest in the production of high-quality, large-sized, and low-cost β-Ga₂O₃ single crystals for the realization of wide-gap semiconductor substrates for power devices.

A β-Ga₂O₃ single crystal considered for device applications can be grown by methods such as the floating zone (FZ) method, the Czochralski (CZ) method, the edge-defined film-fed growth (EFG) method, the vertical Bridgman (VB) method, and the HB method.

Among these crystal growth methods, the FZ method requires no vessel for retaining a raw material melt in terms of the crystal growth principle, and thus the means for heating the raw material to a high temperature (melting point) for melting the raw material can be relatively easily achieved, and many studies thereon have been conducted up to now. However, the FZ method has technical limitations in providing high-quality large crystals with suppressed structural defects such as dislocations, even in consideration of the growth principle and the temperature environment thereof, and it can be said that the FZ method cannot sufficiently response to device applications although much research thereon has been conducted over the past 10 years or more.

Meanwhile, the CZ method and the EFG method have been widely used for growing single crystals, as methods for producing large, high-quality single crystals that are industrially applicable.

As for the growth of β-Ga₂O₃ single crystals, it is presumed that research and development on the CZ method and the EFG method have been actively conducted since 2000. However, large-sized, high-quality, low-cost β-Ga₂O₃ single crystals that can be applied to future power devices have not yet been provided.

Recently, the VB method has received attention to overcome the above problems, and a method for producing large, high-quality, low-cost β-Ga₂O₃ single crystals using the VB method has been actively studied.

When crystal growth is performed using the CZ method and the EFG method, a crucible for accommodating the raw material melt is essential. Since the melting point of β-Ga₂O₃ is high at about 1,800°C, high-melting-point metals such as Ir, Mo, and W can be used as crucible materials that are considered to be applicable from the viewpoint of the melting point.

However, the reducing power of the crucible material, Mo or W, is strong when β-Ga₂O₃ is melted in the crucible at a high temperature exceeding 1,800°C, and Mo and W take oxygen from β-Ga₂O₃, thereby being decomposed and oxidized by themselves, suggesting that they cannot be applied to the crucible at all. As a result, it is recognized that Ir is the only high-melting-point metal applicable to the CZ crucible, EFG crucible, and die materials.

However, it has been clearly revealed through various experiments and theoretical considerations that the currently used CZ crucible material and EFG crucible material (including die material) Ir actually has major problems.

That is, it was found that Ir undergoes an oxidation reaction under an oxygen partial pressure exceeding several percent in a furnace at a high temperature exceeding 1,800°C, and thus is difficult to apply as a stable crucible material. Meanwhile, it was found that β-Ga₂O₃ undergoes a decomposition reaction that loses oxygen under an oxygen partial pressure of 10% or less in a furnace at a high temperature exceeding 1,800°C, and thus is difficult to exist as a stable β-Ga₂O₃ melt.

As described above, it is clear that the oxygen partial pressure condition in the furnace, which is required for the raw material melt β-Ga₂O₃, and the oxygen partial pressure condition required for the Ir crucible that maintains the same, are in conflict. In other words, it is recognized that Ir cannot be a suitable crucible material for accommodating the raw material melt β-Ga₂O₃.

In addition, although the growth of β-Ga₂O₃ crystals by the CZ method and the EFG method using the conventional Ir crucible is possible in a narrow range of oxygen partial pressure of several percent in the furnace, it has been experimentally revealed that there are
the grown β-Ga₂O₃ crystals , there are problems such as the occurrence of high-density oxygen defects that occur frequently in oxide crystals grown under oxygen deficiency, evaporation loss due to oxidation of Ir, and deterioration. In addition, oxygen defects act as n-type impurities and generate high-concentration donors, making it extremely difficult to realize p-type β-Ga₂O₃, and thus presenting many challenges in the realization of semiconductor devices.

To solve these problems, a method of growing β-Ga₂O₃ crystals in an air atmosphere by the VB method using a Pt-Rh alloy crucible was proposed. It was found that since β-Ga₂O₃ crystals are grown in the air, the decomposition of β-Ga₂O³ can be suppressed, and the problem of crucible oxidation at high temperatures can be solved by using a Pt-Rh crucible. However, it has been experimentally revealed that if the β-Ga₂O₃ melt in the Pt-Rh crucible is exposed to a high temperature for a long period of time, a problem arises in that a large amount of Rh is detected as an impurity in the grown β-Ga₂O₃ crystal.

Although the CZ method, the EFG method, and the VB method are all advantageous methods for large-scale production, it has been revealed that a large amount of unintended Si impurities are still detected in β-Ga₂O₃ crystals, and when a device is manufactured using β-Ga₂O₃ crystals containing a large amount of Si impurities, there is a problem in using the crystals as a substrate for manufacturing a device because the crystals do not provide sufficient insulation. In addition, it has been revealed that β-Ga₂O₃ crystals grown by the CZ method and the EFG method contain a large amount of Ga impurities generated by the decomposition of β-Ga₂O₃ in a low-oxygen atmosphere.

### [Prior Art Documents]

### [Patent Documents]

(Patent Document 1) Japanese Patent Application Publication No. 2013-237591

### [Non-Patent Documents]

(Non-Patent Document 1) N. Ueda, H. Hosono, R. Waseda, H. Kawazoe, Appl. Phys. Lett. 70(1997) 3561.

### SUMMARY

The present disclosure has been made in order to solve the above-described problems, and an object of the present disclosure is to provide a single crystal production apparatus that produces a high-quality crystal of ultra-wide bandgap semiconductor gallium oxide, which is essential for the production of extreme environment materials and power devices, by using flame fusion without a crucible for accommodating molten gallium oxide, while preventing the introduction of unintended impurities, and a method for producing a gallium oxide single crystal using the same.

Objects of the present disclosure are not limited to the object mentioned above, and other objects not mentioned will be clearly understood by those skilled in the art to which the present disclosure pertains from the following description.

In order to achieve the above object, the present disclosure provides an apparatus for producing an oxide single crystal, including: a heat source unit 100 configured to melt oxide pellets; a growth unit 200 composed of a refractory material, which is a space for loading the oxide pellets and for growing an oxide single crystal; a driving unit 300 configured to move the entire growth unit in order to grow the oxide single crystal; and a measurement unit 400 configured to measure the temperature of the growth unit throughout the process of growing the oxide single crystal.

The heat source unit 100 may include: a fuel gas supply unit 101 for supplying a fuel gas composed of hydrocarbons; an oxygen gas supply unit 102; a fuel pressure regulator 103 for regulating the pressure of a fuel that is injected into a fuel pipe; an oxygen pressure regulator 104 for regulating the pressure of oxygen; a pre-mixing area unit 107 which is a space where the fuel gas and the oxygen gas are mixed; a fuel pipe 109 through which the fuel gas flows into the pre-mixing area unit 107; an oxygen pipe 110 into which the oxygen gas flows; a fuel flow rate regulator 105 for regulating the amount of the fuel gas flowing into the pre-mixing area unit 107; an oxygen flow rate regulator 106 for regulating the amount of the oxygen gas; a nozzle 108 through which a mixed gas of the fuel gas and the oxygen gas mixed in the pre-mixing area unit 107 is discharged to the outside; and a height adjuster 111 for adjusting the distance between the growth unit 200 and the nozzle 108.

The growth unit 200 may include a refractory insulating material 201 that has heat resistance to the heat generated from the heat source unit 100 and to the surrounding air and serves to provide a space in which an oxygen atmosphere is created.

The driving unit 300 may include: a support 304 that supports the growth unit 200; a conveyor belt 301 that moves the entire support 304 linearly; a motor 302 for driving the conveyor belt 301; a microcontroller 303 for controlling the driving of the motor 302; and a computer C for controlling the microcontroller 303.

The measurement unit 400 may include: an infrared camera 401 that measures the temperature of the growth unit 200; and a computer C that receives measured temperature data from the infrared camera.

The present disclosure also provides a method for producing a gallium oxide single crystal, including: a sample preparation step (S1) of preparing gallium oxide pellets by processing gallium oxide powder; a growth preparation step (S2) of loading the gallium oxide powder pellets into an oxide single crystal production apparatus to create a growth atmosphere and preheating the pellets; and a single crystal growth step (S3) of growing a single crystal by driving a motor, thereby producing a gallium oxide single crystal.

The sample preparation step (S1) may include: a calcination step (S110) of removing organic impurities and moisture from the oxide powder and converting the oxide powder into beta-phase oxide powder; a mixing step S120 of mixing the calcined oxide powder; a cold pressing step (S130) of making the mixed oxide powder into pressed powder; and a sintering step (S140) of heat-treating the pressed oxide powder to prepare pellets.

The growth preparation step (S2) may include: a step (S210) of loading the oxide pellets, prepared in the sample preparation step (S1), into an oxide single crystal production apparatus; a step (S220) of regulating the pressure of fuel gas and oxygen gas for initial flame ignition; a step (S230) of regulating the flow rates of the fuel gas and the oxygen gas; an ignition step (S240) of generating a flame; a step (S250) of increasing the temperature to just before the melting point of the oxide pellets, and then preheating the growth unit and the oxide pellets; a step (S260) of regulating the ratio of the fuel gas to the oxygen gas so that the melting area of the oxide pellets is subjected to an oxygen atmosphere; and a melting step (S270) of heating the sample by increasing the temperature of the oxide pellets to a temperature equal to or higher than the melting point of the oxide pellets.

The oxide single crystal growth step (S3) may include: a step (S310) of initiating oxide single crystal growth by driving a linear motor in a state in which an oxide melt S203 is made at a temperature equal to or higher than the melting point in the growth preparation step (S2); a temperature maintenance step (S320) of regulating the flow rate and pressure of the fuel and the oxygen gas to maintain the temperature of the growth unit; an oxygen atmosphere maintenance step (S330) of regulating the flow rate and pressure to maintain the growth unit in an oxygen atmosphere; a growth step (S340) of growing the oxide single crystal; a cooling step (S350) of cooling the grown oxide single crystal; and a single crystal extraction step (360) of extracting the oxide single crystal grown in the upper portion of the oxide pellets.

The present disclosure also provides a gallium oxide single crystal produced according to the above-described production method.

According to the above-described technical solution of the present disclosure, it is possible to minimize the problem of impurities being introduced by a crucible, by applying a method of using the oxide pellets themselves, which are to be made into a single crystal, as a crucible without using a separate crucible.

In addition, by applying a method of generating heat using a flame consisting of a mixture of a hydrocarbon fuel gas and oxygen gas, the growth atmosphere of the oxide single crystal may be maintained at a high-oxygen atmosphere by regulating the partial pressure of the oxygen gas, so that a high-quality oxide single crystal with few defects may be produced.

In addition, the single crystal produced by the production apparatus of the present disclosure is expected to be used as an ultra-wide bandgap semiconductor material, which is essential for the production of extreme environment materials and power devices, because it is a high-quality crystal obtained by preventing the introduction of unintended impurities during growth.

The effects of the present disclosure are not limited to the effects mentioned above, and other effects not mentioned will be clearly understood by those skilled in the art from the description of the claims.

### BRIEF DESCRIPTION OF THE DRAWINGS

FIG. 1 shows an oxide single crystal production apparatus according to one embodiment of the present disclosure.
FIG. 2 illustrates a heat source unit 100 of the oxide single crystal production apparatus according to one embodiment of the present disclosure.
FIG. 3 illustrates a growth unit 200 of the oxide single crystal production apparatus according to one embodiment of the present disclosure.
FIG. 4 illustrates a driving unit 300 of the oxide single crystal production apparatus according to one embodiment of the present disclosure.
FIG. 5 illustrates a measurement unit 400 of the oxide single crystal production apparatus according to one embodiment of the present disclosure.
FIG. 6 is a process block diagram showing a gallium oxide single crystal production method according to an embodiment of the present disclosure.
FIG. 7 is a process block diagram showing steps S1 to S3 of the gallium oxide single crystal production method according to an embodiment of the present disclosure.
FIG. 8 is a diagram illustrating step S1 of the gallium oxide single crystal production method according to an embodiment of the present disclosure in detail.
FIG. 9 shows a temperature graph of an electric furnace in calcination step S110 of the gallium oxide single crystal production method according to one embodiment of the present disclosure.
FIG. 10 is a photograph showing oxide pellets prepared through cold pressing step S130 of the gallium oxide single crystal production method according to one embodiment of the present disclosure.
FIG. 11 shows a temperature graph of an electric furnace in sintering step S140 of the gallium oxide single crystal production step according to one embodiment of the present disclosure.
FIG. 12 shows an algorithm for growing a single crystal in oxide single crystal growth step S3 of the gallium oxide single crystal production method according to one embodiment of the present disclosure.
FIG. 13 shows a temperature graph in oxide single crystal growth step S3 of the gallium oxide single crystal production method according to one embodiment of the present disclosure.
FIG. 14 shows a micrograph of a gallium oxide single crystal sample grown once using the gallium oxide single crystal production method according to one embodiment of the present disclosure.
FIG. 15 shows the results of X-ray and neutron diffraction analysis of a gallium oxide single crystal produced according to one embodiment of the present disclosure. Specifically, FIG. 15(a) shows an X-ray Laue pattern of the (0 K 0) plane. FIG. 15(b) includes the results of rocking curve measurement, in which the left curve of the corresponding region shows X-ray diffraction data, and the center and right curves show neutron diffraction data. FIG. 15(c) shows X-ray 2θ/θ scan data along the (H 0 0) direction.

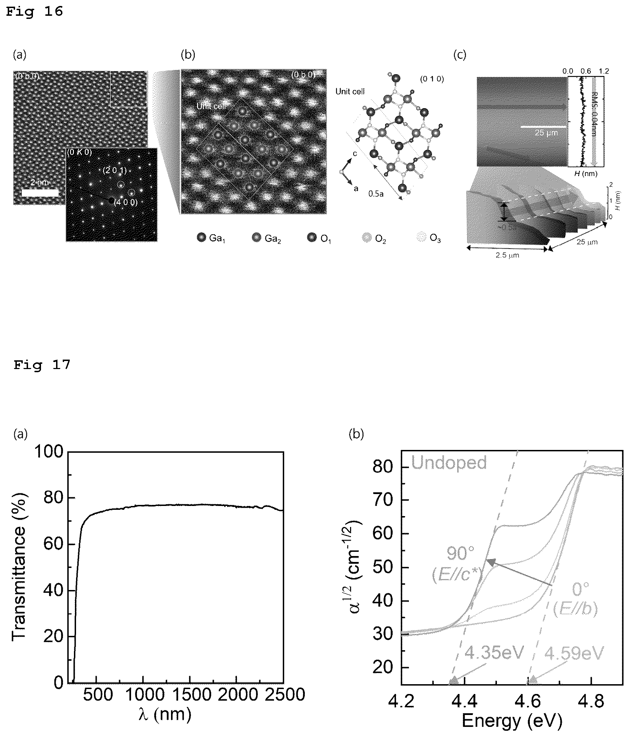

FIG. 16 shows TEM and AFM micrographs of a gallium oxide single crystal produced according to one embodiment of the present disclosure. Specifically, FIG. 16(a) shows a transmission electron microscope (TEM) image of the (0 b 0) plane of the gallium oxide single crystal measured and an electron diffraction pattern along the (0 K 0) plane. FIG. 16(b) is an enlarged TEM image (left) of the area indicated in FIG. 16(a), and shows the unit cell of the gallium oxide single crystal. In addition, FIG. 16(b) schematically shows the unit cells (right). FIG. 16(c) shows an atomic force microscope (AFM) image of the grown undoped gallium oxide single crystal.
FIG. 17 shows the results of measurement using ultraviolet-visible-near infrared spectroscopy of a gallium oxide single crystal produced according to one embodiment of the present disclosure.
FIG. 18 shows the results of measurement using secondary ion mass spectrometry of a gallium oxide single crystal produced according to one embodiment of the present disclosure.

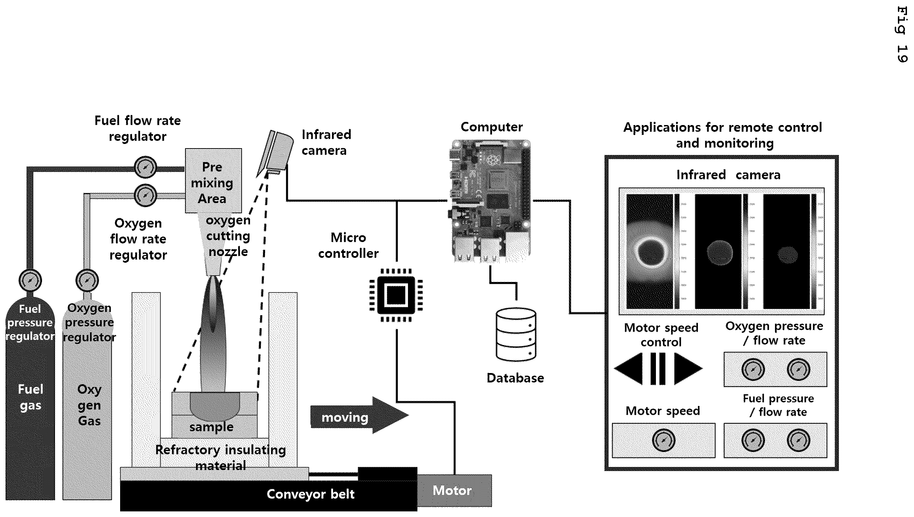

FIG. 19 is a conceptual diagram showing an apparatus for producing a gallium oxide crystal and a method for producing a gallium oxide crystal according to one embodiment of the present disclosure.

### DETAILED DESCRIPTION

The terms used in the present specification are currently widely used general terms selected in consideration of their functions in the present disclosure, but they may change depending on the intents of those skilled in the art, precedents, or the advents of new technology. Additionally, in certain cases, there may be terms arbitrarily selected by the applicant, and in this case, their meanings are described in a corresponding description part of the present disclosure. Accordingly, the terms used in the present disclosure should be defined based on the meaning of the term and the entire contents of the present disclosure, rather than the simple term name.

Unless otherwise defined, all terms (including technical or scientific terms) used herein have the same meanings as commonly understood by those skilled in the art to which the present disclosure pertains. In general, the nomenclature used in the present specification is well known and commonly used in the art.

The terms used in general and defined in dictionaries should be interpreted as having meanings identical to those specified in the context of related technology. Unless definitely defined in the present application, the terms should not be interpreted as having ideal or excessively formative meanings.

Throughout the specification, it should be understood that when any part is referred to as "including" any component, it does not exclude other components, but may further include other components, unless otherwise specified.

Hereinafter, embodiments of the present disclosure will be described are described in detail with reference to the accompanying drawings so that those skilled in the art can easily carry out the present disclosure. However, the present disclosure may be embodied in various different forms and is not limited to the embodiments described herein.

The present disclosure provides an oxide single crystal production apparatus T including: a heat source unit 100 configured to melt oxide pellets; a growth unit 200 composed of a refractory material, which is a space for loading the oxide pellets and for growing an oxide single crystal; a driving unit 300 configured to move the entire growth unit in order to grow the oxide single crystal; and a measurement unit 400 configured to measure the temperature of the growth unit throughout the process of growing the oxide single crystal

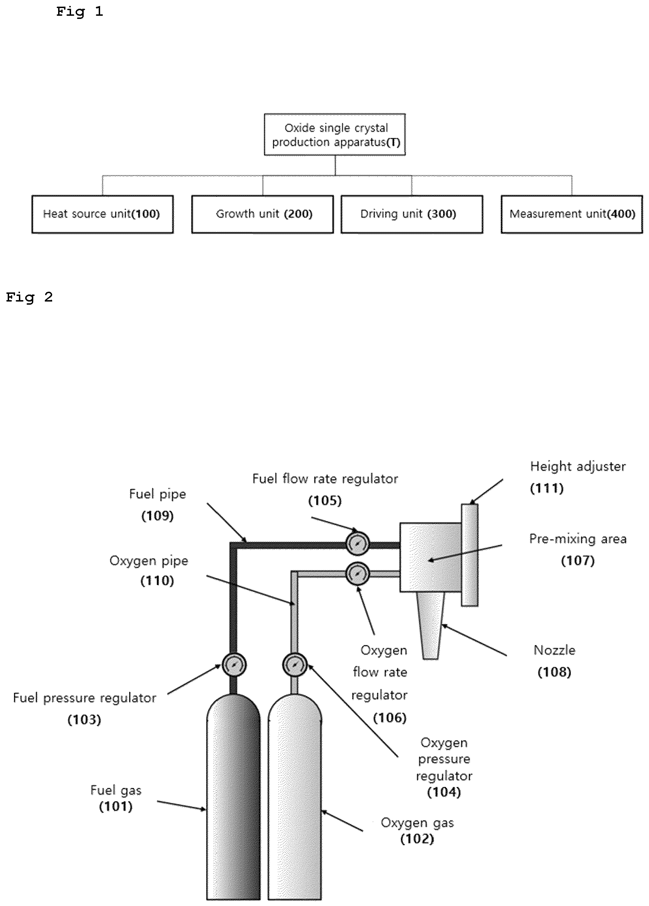

As shown in FIG. 2, the heat source unit 100 may include: a fuel gas supply unit 101 for supplying a fuel gas composed of hydrocarbons; an oxygen gas supply unit 102; a fuel pressure regulator 103 for regulating the pressure of a fuel that is injected into a fuel pipe; an oxygen pressure regulator 104 for regulating the pressure of oxygen; a pre-mixing area unit 107 which is a space where the fuel gas and the oxygen gas are mixed; a fuel pipe 109 through which the fuel gas flows into the pre-mixing area unit 107; an oxygen pipe 110 into which the oxygen gas flows; a fuel flow rate regulator 105 for regulating the amount of the fuel gas flowing into the pre-mixing area unit 107; an oxygen flow rate regulator 106 for regulating the amount of the oxygen gas; a nozzle 108 through which a mixed gas of the fuel gas and the oxygen gas mixed in the pre-mixing area unit 107 is discharged to the outside; and a height adjuster 111 for adjusting the distance between the growth unit 200 and the nozzle 108.

As the fuel gas, a gas composed of hydrocarbons may be mainly used, and examples thereof include gases such as hydrogen, propane, butane, and acetylene.

The fuel pressure regulator 103, the oxygen pressure regulator 104, the fuel flow rate regulator 105 and the oxygen flow rate regulator 106 may be devices in analog or digital format, and more preferably, may be devices in digital format capable of communication, without being limited thereto.

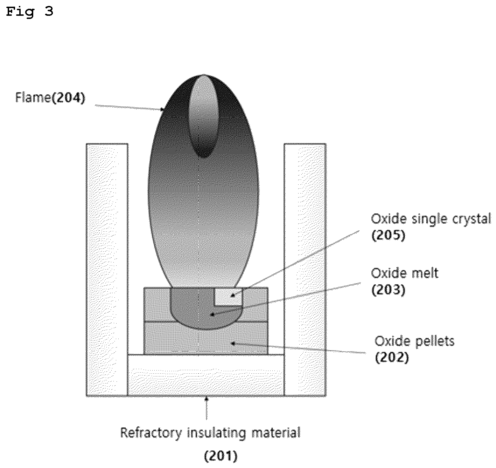

As shown in FIG. 3, the growth unit 200 may include: a refractory insulating material 201 that has heat resistance to the heat generated from the heat source unit 100 and to the surrounding air and serves to provide a space in which an oxygen atmosphere is created; oxide pellets 202; a flame 204 that forms an oxygen atmosphere with the heat generated from the heat source unit 100; an oxide melt 203 in which the oxide pellets 202 heated by the flame are melted; and an oxide single crystal 205 formed by slow cooling and crystallization of the oxide melt 203.

According to one embodiment of the present disclosure, the oxide sample is not prepared in a powder form because the sample is subjected to strong gas pressure by a flame, but is prepared in a pellet form through cold pressing and sintering processes, thereby preventing loss of the raw material and allowing the melt to be retained without a crucible.

As the refractory insulating material 201, an appropriate refractory insulating material may be selected depending on the melting point of the oxide to be melted. Preferably, the refractory insulating material 201 may be made of zirconia, without being limited thereto.

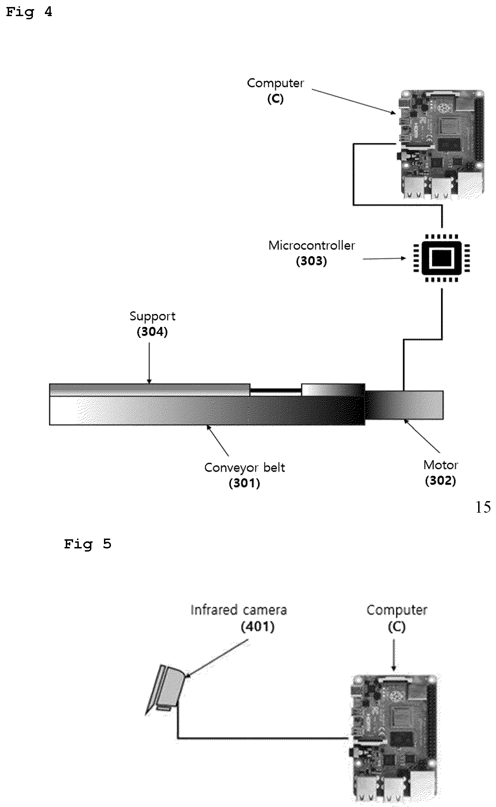

As shown in FIG. 4, the driving unit 300 may include: a support 304 that supports the growth unit 200; a conveyor belt 301 that moves the entire support 304 linearly; a motor 302 for driving the conveyor belt 301; a microcontroller 303 for controlling the driving of the motor 302; and a computer C for controlling the microcontroller 303.

The refractory insulating material 201 and the oxide pellets are both placed on the conveyor belt, and when the oxide pellets are heated by a flame and the internal temperature of the refractory insulating material 201 reaches an equilibrium state, a melt is generated in the oxide pellets, and the entire refractory insulating material 201 is moved horizontally by the conveyor belt.

The support 304 is a part that is exposed to a high temperature during oxide single crystal growth. The support 304 may be made of a suitable metal material having a sufficiently high melting point so that it is not damaged. Preferably, the support 304 may be made of at least one selected from the group consisting of aluminum and stainless steel, without being limited thereto.

The conveyor belt 301 is connected to a motor 302, the motor 302 is connected to a microcontroller 303, and the movement of the conveyor belt 301 is controlled by the microcontroller 303 and driven by the motor 302.

The microcontroller 303 is connected to the computer C and receives a command signal by a program installed in the computer C.

As shown in FIG. 5, the measurement unit 400 may include: an infrared camera 401 that measures the temperature of the growth unit 200; and a computer C that receives measured temperature data from the infrared camera.

The infrared camera 401 measures the temperature of the growth unit 200, and transmits the temperature data of the growth portion 200 to the computer in real time, and the temperature data is output as an image by a program that can view the same as a real-time image.

In addition, the system is controlled through an algorithm by which the temperature of the infrared camera 401 is measured and, if it is lower than the temperature set in the program, the temperature is increased by regulating the fuel flow rate regulator 105, and if the temperature is higher than the temperature set in the program, it is lowered by regulating the fuel flow rate regulator 105, thereby maintaining the set temperature.

The present disclosure also provides a method for producing a gallium oxide single crystal, including: a sample preparation step (S1) of preparing gallium oxide pellets by processing gallium oxide powder; a growth preparation step (S2) of loading the gallium oxide powder pellets into the oxide single crystal production apparatus to create a growth atmosphere and preheating the pellets; and a single crystal growth step (S3) of growing a single crystal by driving a motor, thereby producing a gallium oxide single crystal.

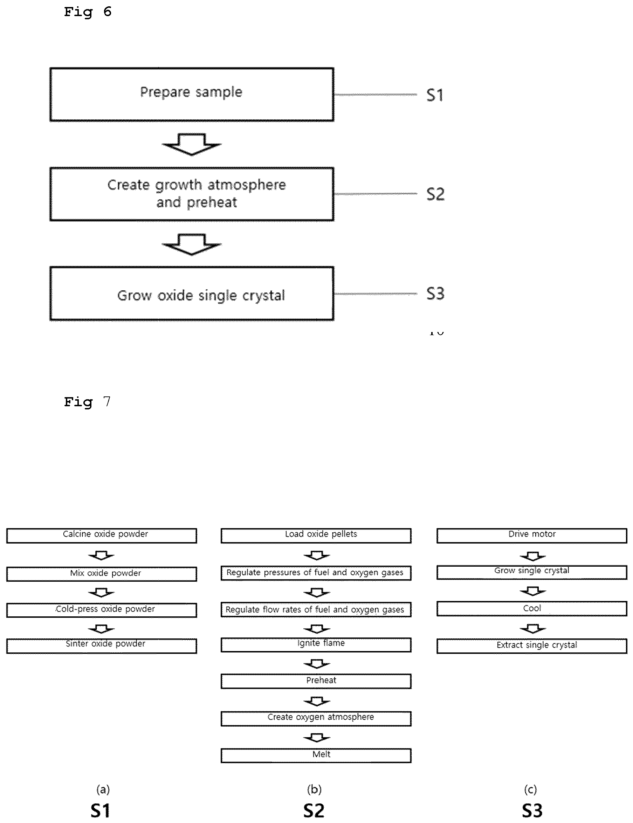

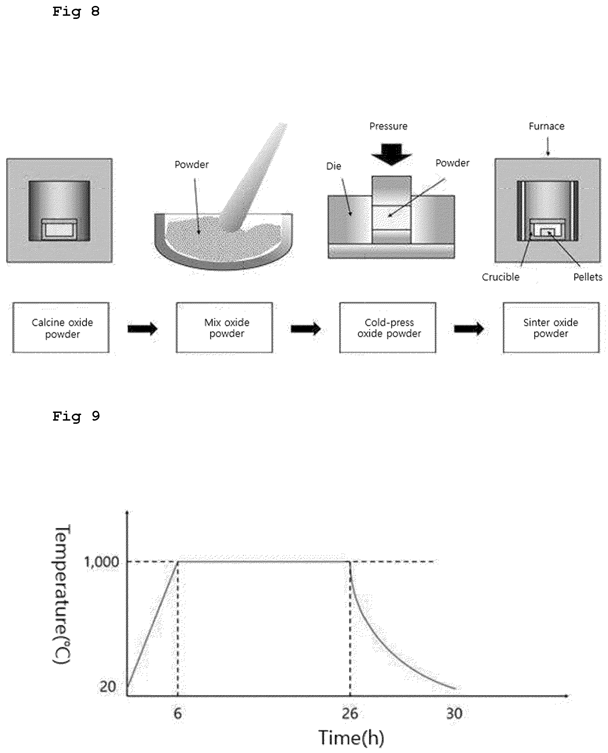

As shown in FIGS. 7(a) and 8, the sample preparation step (S1) may include: a calcination step (S110) of removing organic impurities and moisture from the oxide powder and converting the oxide powder into beta-phase oxide powder; a mixing step (S120) of mixing the calcined oxide powder; a cold pressing step (S130) of making the mixed oxide powder into pressed powder; and a sintering step (S140) of heat-treating the pressed oxide powder to prepare pellets.

According to one embodiment of the present disclosure, the gallium oxide sample is not prepared in a powder form because it is subjected to strong gas pressure by a flame, but is prepared in a pellet form through cold pressing and sintering processes, thereby preventing loss of the raw material and allowing the melt to be retained without a crucible.

As shown in FIG. 7(b), the growth preparation step (S2) may include: a step (S210) of loading the sintered gallium oxide pellets, prepared in the sample preparation step (S1), into the oxide single crystal production apparatus T; a step (S220) of regulating the pressure of fuel gas and oxygen gas for initial flame ignition; a step (S230) of regulating the flow rates of the fuel gas and the oxygen gas; an ignition step (S240) of generating a flame; a step (S250) of increasing the temperature to just before the melting point of the oxide pellets, and then preheating the growth unit and the oxide pellets; a step (S260) of regulating the ratio of the fuel gas to the oxygen gas so that the melting area of the oxide pellets is subjected to an oxygen atmosphere; and a melting step (S270) of heating the sample by increasing the temperature of the oxide pellets to a temperature equal to or higher than the melting point of the oxide pellets.

As shown in FIG. 7(c), the oxide single crystal growth step (S3) may include: a step (S310) of initiating oxide single crystal growth by driving a linear motor in a state in which an oxide melt S203 is made at a temperature equal to or higher than the melting point in the growth preparation step (S2); a temperature maintenance step (S320) of regulating the flow rate and pressure of the fuel and the oxygen gas to maintain the temperature of the growth unit 200; an oxygen atmosphere maintenance step (S330) of regulating the flow rate and pressure to maintain the growth unit in an oxygen atmosphere; a growth step (S340) of growing the gallium oxide single crystal 205; a cooling step (S350) of cooling the grown gallium oxide single crystal; and a single crystal extraction step (360) of extracting the gallium oxide single crystal grown in the upper portion of the gallium oxide pellets.

Hereinafter, each step of the method for producing a gallium oxide single crystal according to one embodiment of the present disclosure will be described in detail.

The gallium oxide powder calcination step (S110) is may include selecting a crucible material that does not react with the gallium oxide powder to form a new compound, loading the gallium oxide powder into the crucible, heating the gallium oxide powder to an appropriate temperature in an electric furnace, maintaining the gallium oxide powder for an appropriate time, and naturally cooling the gallium oxide powder to the ambient temperature without a cooling device.

The most suitable material for the crucible for accommodating the gallium oxide powder is platinum or a platinum-based alloy that does not chemically react with the gallium oxide powder.

As shown in FIG. 9, in the gallium oxide powder calcination step (S110), a platinum crucible containing 100 g of the gallium oxide powder is loaded into an electric furnace, heated to 1,000°C for 6 hours, maintained at 1,000°C for 20 hours, and then naturally cooled to ambient temperature in a state in which the electric furnace is turned off.

As shown in FIG. 8, the raw material powder mixing step (S120) includes performing a milling process to refine the particle size of the gallium oxide powder subjected to the gallium oxide powder calcination step (S110), make the particle size distribution uniform, and ensure that the gallium oxide powder is well mixed.

The milling process may be performed using a mortar and pestle, a ball mill, or a high-energy ball mill. In the present disclosure, about 90 to 100 g of the gallium oxide powder subjected to the calcination step (S110) may be milled using a mortar and pestle for 30 minutes.

The gallium oxide powder cold pressing step (S130) may include placing the powder, subjected to the gallium oxide powder mixing step (S120), into a die made of an alloy metal that can accommodate the powder, and pressing the powder without applying heat, thereby making the powder into a pellet shape.

In the cold pressing step (S130) of making the mixed powder into pressed powder, 40 g of the gallium oxide powder subjected to the gallium oxide powder mixing step (S120) may be loaded into a cylindrical stainless steel die with a diameter of 1.5 inches, and maintained at a pressure of 70 MPa for 5 minutes using a hydraulic press device, and then the cold-pressed gallium oxide powder may be isolated. The cold pressing step may be performed in the same manner twice.

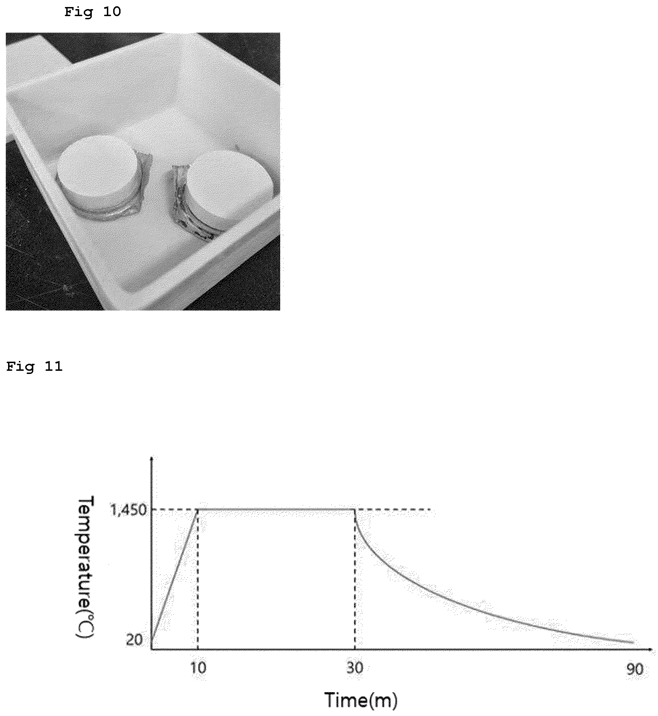

The sintering step (S140) may include, as shown in FIG. 10, loading the pellets, prepared through the gallium oxide powder cold pressing step (S130), into an alumina crucible using a platinum crucible lid that does not chemically react as a support, and as shown in FIG. 11, heating the pellets to 1,450 °C for 8 hours in an electric furnace, maintaining the pellets at 1,450 °C for 20 hours, and then naturally cooling the pellets to ambient temperature in a state in which the electric furnace is turned off.

As shown in FIG. 3, the gallium oxide pellet loading step (S210) may include preparing two gallium oxide pellets (202) prepared through the gallium oxide powder sintering step (S140), and loading the gallium oxide pellets 202 in a stacked manner at the bottom of the growth unit 200 of the single crystal production apparatus T so that the melt does not overflow to the bottom of the growth unit 200 during the melting process.

The fuel gas and oxygen gas pressure regulation step (S220) and the fuel gas and oxygen gas flow rate regulation step (S230) may include regulating the pressure and the flow rate to levels suitable for igniting an initial flame.

The flame ignition step (S240) may include applying heat equal to or higher than the ignition point to the tip of the nozzle 108 to generate a flame in the gas coming out of the nozzle 108. The fuel gas that is used in the flame ignition step (S240) is a portable LPG gas in which butane and propane gases are mixed at a ratio of 9:1.

The preheating step (S250) may include slowly heating the gallium oxide pellets 202 to just before the melting temperature of about 1,850°C, by regulating the pressures and flow rates of the fuel and the oxygen gas so that the gallium oxide pellets 202 do not crack due to thermal shock, and maintaining the temperature of the growth unit 200 until it reaches thermal equilibrium.

The oxygen atmosphere creation step (S260) may include regulating the pressure and flow rate of oxygen maintain an appropriate oxygen partial pressure for melting the gallium oxide pellets 202 and maintain the temperature in the preheating step (S250).

The melting step (S270) of heating the sample by increasing the temperature to a temperature equal to or higher than the melting point of the gallium oxide pellets may include melting the gallium oxide pellets 202 by regulating the flow rates and pressures of the fuel and the oxygen gas to heat the gallium oxide pellets to a temperature equal to or higher than the melting point while maintaining the oxygen atmosphere created in the oxygen atmosphere creation step (S260), thereby producing the gallium oxide melt 203.

In the melting step (S270), a gallium oxide melt should be made such that a sufficient crystal size may be formed in the upper portion of the gallium oxide pellets 202, and thus the area of the flame 205 with a temperature higher than the melting point should be sufficiently large.

In addition, if the area of the flame 205 with a temperature higher than the melting point becomes larger than the diameter of the pellet 202, the gallium oxide melt 203 may overflow to the bottom of the growth unit 200, and thus the area of the flame 205 should be maintained by appropriately regulating the pressures and flow rates of the fuel gas and the oxygen gas.

The linear motor driving step (S310) and the single crystal growth step (S320) may include, when the gallium oxide melt 203 formed at a temperature equal to or higher than the melting point in the melting step (S270) reaches a state of thermal equilibrium in the growth unit 200, driving the linear motor to grow the gallium oxide single crystal, and continuously regulating the pressures and flow rates of the fuel and the oxygen gas to maintain the temperature and oxygen atmosphere at the time point when melting begins.

In the linear motor driving step (S310), the movement speed of the motor may be 0.3 to 0.7 mm/min, preferably, 0.5 mm/min. As the movement speed of the motor decrease, the size of the crystal may increase and the quality of the crystal may become better.

According to one embodiment of the present disclosure, when a thermal equilibrium state is reached in the linear motor driving step (S310), the temperature is about 1,950°C, the pressure of the fuel gas is about 0.05 MPa, and the pressure of the oxygen gas is about 0.02 MPa.

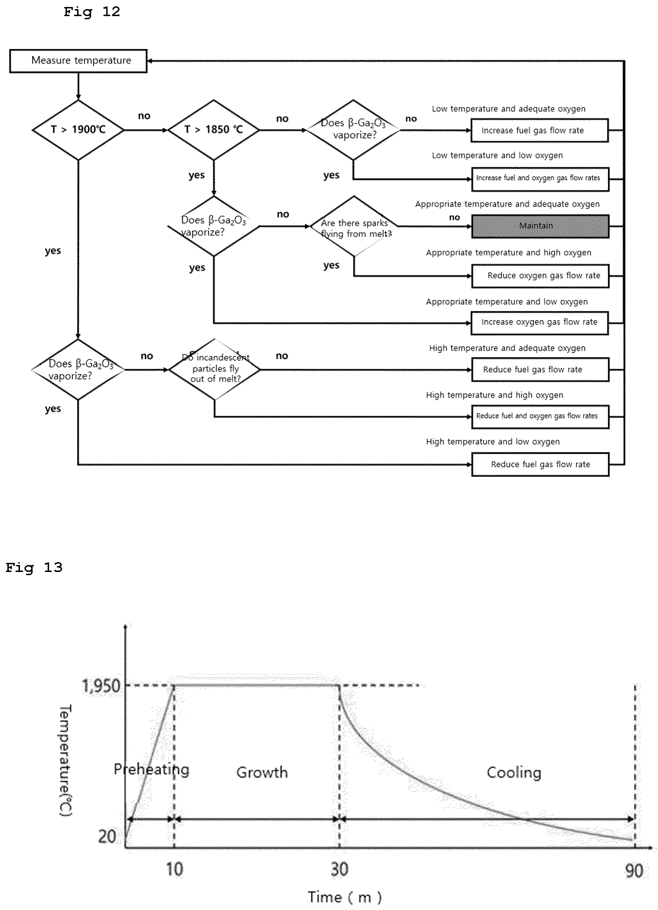

The single crystal growth step (S320) may be controlled by an algorithm as shown in FIG. 12 to continuously maintain the temperature and the oxygen atmosphere while the entire growth unit 200 is placed on the support 304 of the driving unit 300 and moves in a straight direction at a constant speed.

In addition, the cooling step (S330) may include rapidly reducing the flow rates and pressures of the fuel and the oxygen gas to reduce the temperature of the flame 204 after completion of growth of the gallium oxide single crystal, and covering the upper part of the growth unit 200 with a refractory insulating material 201 to slowly reduce the temperature of the growth unit 200 to the ambient temperature.

In addition, the single crystal extraction step (S340) may include appropriately processing the gallium oxide single crystal 205 generated in the upper portion of the gallium oxide pellets 202 cooled to ambient temperature and selecting the single crystal.

The present disclosure also provides a gallium oxide single crystal produced according to the above-described production method.

Hereinafter, the present disclosure will be described in detail by way of examples. However, the examples according to the present disclosure may be modified into various different forms, and the scope of the present disclosure should not be construed as being limited to the examples described below. The examples in the present specification are provided to more completely explain the present disclosure to those skilled in the art.

### <Example> Production of β-Ga₂O₃ Crystal

### 1. Preparation of β-Ga₂O₃ Pellets

(a) 100 g of β-Ga₂O₃ powder was placed in a platinum crucible which was then placed in the center of an electric furnace.
(b) The powder was heated to a temperature of 1,000°C for 6 hours in the electric furnace, maintained at 1,000°C for 20 hours, and then naturally cooled to ambient temperature in a state in which the electric furnace was turned off.
(c) The β-Ga₂O₃ powder calcined in (b) was placed in a mortar and pestle and ground for 30 minutes.
(d) 40 g of the β-Ga₂O₃ powder ground in (c) was placed in a 1.5-inch-diameter circular alloy metal die and maintained at a pressure of 70 MPa for 5 minutes using a hydraulic press. This process was repeated twice.
(e) Two cold-pressed β-Ga₂O₃ powder pellets taken out from the die were placed on a platinum crucible lid holder, placed in an alumina crucible, and positioned in the center of an electric furnace.
(f) The pellets were heated to a temperature of 1,450°C for 8 hours in the electric furnace, maintained at 1,450°C for 20 hours, and then naturally cooled to ambient temperature in a state in which the electric furnace was turned off.

### 2. Production of β-Ga₂O₃ Single Crystal

(g) The sintered β-Ga₂O₃ pellets sintered in (f) were loaded on the lower central part of the growth unit.
(h) An LPG fuel gas consisting of a 9:1 mixture of propane and butane and oxygen gas were used, and the valve of the gas tank was opened for flame ignition, and the fuel gas pressure regulator and the oxygen gas pressure regulator were appropriately adjusted to ignite the flame.
(i) After ignition of the flame, the fuel gas flow rate meter and the oxygen gas flow rate regulator were slowly opened, and the fuel gas pressure regulator and the oxygen gas pressure regulator were adjusted to increase the temperature of the flame.
(j) After the flame temperature increased to about 1,450°C, the pressure regulators and the flow rate regulators were adjusted by applying the algorithm shown in FIG. 12 to create a high-oxygen atmosphere so that the β-Ga₂O₃ pellets did not vaporize and fly away. When the β-Ga₂O₃ pellets were exposed to the high-oxygen atmosphere, the powder did not vaporize and fly away.
(k) After the high-oxygen atmosphere was formed at a temperature equal to or higher than 1,450°C, the algorithm shown in FIG. 12 was applied in the same manner as in (j) to melt the β-Ga₂O₃ pellets to generate a melt while slowly increasing the flow rates and pressures of the fuel gas and the oxygen gas, and the temperature was increased to 1,950°C and maintained for about 10 minutes so that the entire system reached thermal equilibrium.
(1) When the β-Ga₂O3 melt was generated and thermal equilibrium was reached so that the melt area was maintained constant, the motor was driven to initiate single crystal growth. The motor speed was set so that the entire growth unit moved at 0.5 mm/min.
(m) The algorithm shown in FIG. 12 was applied to maintain the growth temperature and oxygen atmosphere stably until single crystal growth was completed.
(n) After completion of single crystal growth, the flame was turned off and the pellets were slowly cooled.
(o) A single crystal was extracted from the upper portion of the cooled β-Ga₂O₃ pellets.

### <Experimental Example> Evaluation of β-Ga₂O₃ Crystal

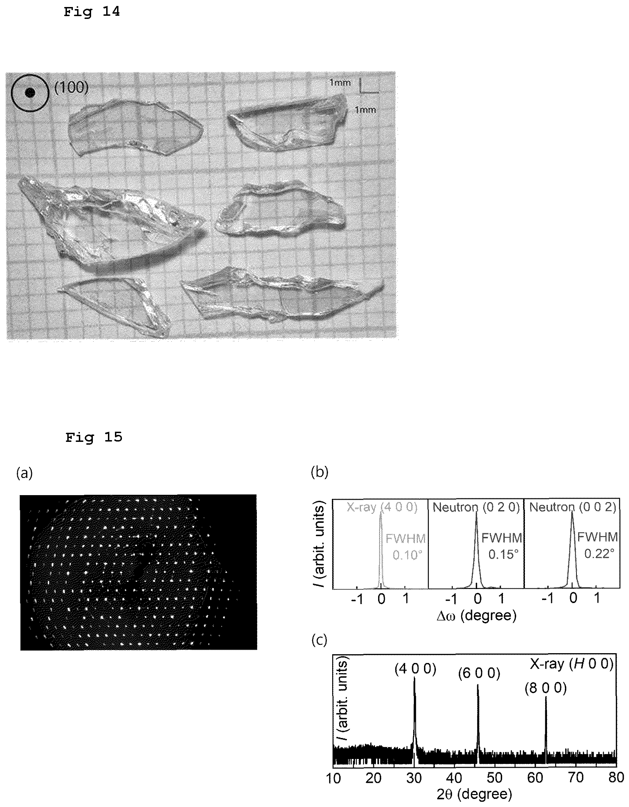

FIG. 14 is a micrograph of the β-Ga₂O₃ single crystal sample produced according to one example of the present disclosure. The β-Ga₂O₃ single crystal sample shown in FIG. 14 is a β-Ga₂O₃ single crystal sample grown once through the process of the above Example (Production of β-Ga₂O₃ Crystal).

FIGS. 15(a), 15(b) and 15(c) show the results of measuring the structure of the β-Ga₂O₃ single crystal sample, produced according to one example of the present disclosure, by single crystal X-ray diffraction analysis and neutron diffraction analysis. FIG. 15(a) shows the X-ray Laue pattern along the (0K0) plane, with the (210) plane indicated on the pattern. FIG. 15(b) shows the rocking curve data, with X-ray data on the left and neutron data in the middle and right, and the measured planes are (400), (020), and (002), which have FWHM values of 0.12°, 0.14°, and 0.26°, respectively. FIG. 15(c) shows the X-ray 2θ/θ scan data along the (H00) direction.

**In** addition, the crystal structure and lattice constant of the β-Ga₂O₃ single crystal sample produced according to one example of the present disclosure were analyzed by single crystal X-ray diffraction analysis, and the results are shown in Table 1 below. Referring to Table 1 below, it could be confirmed that the crystal structure was monoclinic, the lattice constant values were a = 12.231Å, b = 3.0359Å, c = 5.8077Å, α = 90°, β = 103.784°, and γ = 90°, and the unit cell volume was 209.44Å³.

**[Table 1]**

| **Lattice constant** | **Measured value** | **Literature value** |
|---|---|---|
| a | 12.231Å | 12.214Å |
| b | 3.0359Å | 3.0371Å |
| c | 5.8077Å | 5.7981Å |
| α | 90° | 90° |
| β | 103.784° | 103.830° |
| γ | 90° | 90° |
| Unit cell volume | 209.44Å³ | 208.85Å³ |

In addition, FIGS. 16(a), 16(b) and 16(c) show the results of analyzing the atomic arrangement and surface state of the β-Ga₂O₃ single crystal sample, produced according to one example of the present disclosure, by TEM and AFM microscopic analysis. FIG. 16(a) shows an image observed along the (0b0) plane and an electron diffraction pattern along the (0 K 0) plane, and picks are marked on the electron diffraction pattern in the directions of (201) and (400) planes. FIG. 16(b) is an enlarged TEM image (left) of the area indicated in FIG. 16(a), and shows the unit cell of the β-Ga₂O₃ single crystal, and a schematic diagram of the unit cell is shown on the right. FIG. 16(c) is an atomic force microscope (AFM) image of the grown undoped β-Ga₂O₃, in which the total horizontal length indicated by the blue arrow is 50 µm, the surface roughness is 0.04 nm, and the step height along the direction indicated by the red arrow corresponds to 0.5a of the β-Ga₂O₃ unit cell, which is about 0.6 nm.

In addition, FIG. 17 shows the results of analyzing the β-Ga₂O₃ single crystal sample, produced according to one example of the present disclosure, by ultraviolet-visible-near-infrared spectroscopy. As shown therein, it could be confirmed that the direct bandgap value was a value of 4.35 to 4.59 eV along the c* crystal axis and the b crystal axis.

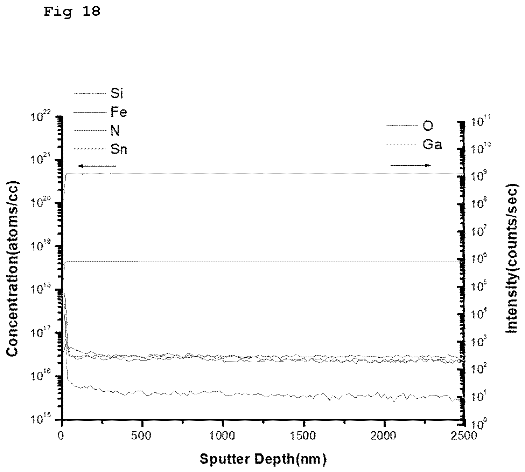

In addition, FIG. 18 shows the results of analyzing the β-Ga₂O₃ single crystal sample, produced according to one example of the present disclosure, by secondary ion mass spectrometry. As shown therein, it could be confirmed that the concentration of Si impurities was 2.28 x 10¹⁶, the concentration of Fe impurities was 2.85 x 10¹⁶, the concentration of N impurities was 3.53 x 10¹⁵, and the concentration of Sn impurities was 2.38 x 10¹⁶.

So far, the present disclosure has been described with reference to the specific embodiments. Those of ordinary skill in the art to which the present disclosure pertains will appreciate that the present disclosure may be embodied in modified forms without departing from the essential characteristics of the present disclosure. Therefore, the disclosed embodiments should be considered from an illustrative point of view, not from a restrictive point of view. The scope of the present disclosure is defined by the claims rather than the foregoing description, and all differences within the scope equivalent thereto should be construed as being included in the present disclosure.

## Claims

1. An apparatus for producing an oxide single crystal, comprising:
a heat source unit 100 configured to melt oxide pellets;
a growth unit 200 composed of a refractory material, which is a space for loading the oxide pellets and for growing an oxide single crystal;
a driving unit 300 configured to move the entire growth unit in order to grow the oxide single crystal; and
a measurement unit 400 configured to measure a temperature of the growth unit throughout a process of growing the oxide single crystal.

2. The apparatus of claim 1, wherein the heat source unit 100 comprises:
a fuel gas supply unit 101 for supplying a fuel gas composed of hydrocarbons;
an oxygen gas supply unit 102;
a fuel pressure regulator 103 for regulating a pressure of a fuel that is injected into a fuel pipe;
an oxygen pressure regulator 104 for regulating a pressure of oxygen;
a pre-mixing area unit 107 which is a space where the fuel gas and the oxygen gas are mixed;
a fuel pipe 109 through which the fuel gas flows into the pre-mixing area unit 107;
an oxygen pipe 110 into which the oxygen gas flows;
a fuel flow rate regulator 105 for regulating an amount of the fuel gas flowing into the pre-mixing area unit 107;
an oxygen flow rate regulator 106 for regulating an amount of the oxygen gas;
a nozzle 108 through which a mixed gas of the fuel gas and the oxygen gas mixed in the pre-mixing area unit 107 is discharged to an outside; and
a height adjuster 111 for adjusting a distance between the growth unit 200 and the nozzle 108.

3. The apparatus of claim 1, wherein the growth unit 200 comprises a refractory insulating material 201 that has heat resistance to heat generated from the heat source unit 100 and to a surrounding air and serves to provide a space in which an oxygen atmosphere is created.

4. The apparatus of claim 1, wherein the driving unit 300 comprises:
a support 304 that supports the growth unit 200;
a conveyor belt 301 that moves the entire support 304 linearly;
a motor 302 for driving the conveyor belt 301;
a microcontroller 303 for controlling the driving of the motor 302; and
a computer C for controlling the microcontroller 303.

5. The apparatus of claim 1, wherein the measurement unit 400 comprises:
an infrared camera 401 that measures a temperature of the growth unit 200; and
a computer C that receives measured temperature data from the infrared camera.

6. A method for producing a gallium oxide single crystal, comprising:
a sample preparation step (S1) of preparing gallium oxide pellets by processing gallium oxide powder;
a growth preparation step (S2) of loading the gallium oxide powder pellets into an oxide single crystal production apparatus to create a growth atmosphere and preheating the pellets; and
a single crystal growth step (S3) of growing a single crystal by driving a motor, thereby producing a gallium oxide single crystal.

7. The method of claim 6, wherein the sample preparation step (S1) comprises:
a calcination step (S110) of removing organic impurities and moisture from the gallium oxide powder and converting the gallium oxide powder into beta-phase oxide powder;
a mixing step S120 of mixing the calcined gallium oxide powder;
a cold pressing step (S130) of making the mixed gallium oxide powder into pressed powder; and
a sintering step (S140) of heat-treating the pressed gallium oxide powder to prepare pellets.

8. The method of claim 6, wherein the growth preparation step (S2) comprises:
a step (S210) of loading the oxide pellets, prepared in the sample preparation step (S1), into the oxide single crystal production apparatus;
a step (S220) of regulating pressures of fuel gas and oxygen gas for initial flame ignition;
a step (S230) of regulating flow rates of the fuel gas and the oxygen gas;
an ignition step (S240) of generating a flame;
a step (S250) of increasing a temperature of the gallium oxide pellets to just before a melting point of the gallium oxide pellets, and then preheating the growth unit and the gallium oxide pellets;
a step (S260) of regulating a ratio of the fuel gas to the oxygen gas so that a melting area of the oxide pellets is subjected to an oxygen atmosphere; and
a melting step (S270) of heating the sample by increasing the temperature of the gallium oxide pellets to a temperature equal to or higher than the melting point of the gallium oxide pellets.

9. The method of claim 6, wherein the oxide single crystal growth step (S3) comprises:
a step (S310) of initiating oxide single crystal growth by driving a linear motor in a state in which an oxide melt is made at a temperature equal to or higher than the melting point in the growth preparation step (S2);
a temperature maintenance step (S320) of regulating flow rates and pressures of the fuel gas and the oxygen gas to maintain a temperature of the growth unit;
an oxygen atmosphere maintenance step (S330) of regulating the flow rates and pressures to maintain the growth unit in an oxygen atmosphere;
a growth step (S340) of growing the oxide single crystal;
a cooling step (S350) of cooling the grown oxide single crystal; and
a single crystal extraction step (360) of extracting the oxide single crystal grown in an upper portion of the oxide pellets.

10. A gallium oxide single crystal produced according to the method of claim 6.
